(19) Europäisches Patentamt European Patent Office Office européen des brevets

(11) **EP 1 858 160 A1**

(12) **EUROPEAN PATENT APPLICATION**

(43) Date of publication:
   **21.11.2007 Bulletin 2007/47**

(51) Int Cl.:
   ***H03F 3/45*** (2006.01)

(21) Application number: **06252549.8**

(22) Date of filing: **16.05.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU**<br><br>(71) Applicant: **STMicroelectronics (Research & Development) Limited**<br>**Marlow,**<br>**Buckinghamshire SL7 1YL (GB)** | (72) Inventor: **Thies, William**<br>**Bristol BS35 4EA (GB)**<br><br>(74) Representative: **Loveless, Ian Mark**<br>**Reddie & Grose,**<br>**16 Theobalds Road**<br>**London WC1X 8PL (GB)** |

(54) **Amplifier arrangement**

(57)  An integrated circuit for amplifying electrical signals received from a light sensor/ detector in an optical disc reader comprises a transconductor circuit and a transimpedence circuit coupled together. The a transconductor circuit comprising a first cross-coupled differential pair having input terminals arranged to receive a differential voltage and intermediate output terminals arranged to produce a differential current. The a transimpedence circuit comprising a second cross-coupled differential pair with input and output connected with negative feedback and having input terminals connected to the intermediate output terminals.

FIGURE 4

**Description**

FIELD OF THE INVENTION

The present invention relates to an amplifier arrangement, in particular to a variable gain amplifier. The invention also relates to a transimpedence arrangement for use in an amplifier.

BACKGROUND OF THE INVENTION

Voltage amplification is needed in many semiconductor devices and various amplification arrangements are known. One example of the need for amplification is in DVD players in which a photodiode generates an output voltage from optical sensing of a DVD surface. Prior to digitising the voltage signal, gain is applied using an amplifier so that the voltage range is suited to the A to D converter. The voltage range received from the photodiode will vary depending upon the type of disk used: pre-recorded DVD disks produce higher voltage ranges due to high reflectivity and so need lower gain in contrast to recordable disks.

SUMMARY OF THE INVENTION

We have appreciated the need for a variable gain amplifier for the above purpose and for other circuits also requiring variable voltage gain or attenuation. We have also appreciated the need for an improved amplifier arrangement having a wide, fully differential input and output voltage range, maximising the signal to noise ratio of the system, suitable for sub 2.5V power supply voltages. The invention is defined in the claims to which reference is now directed.
A first aspect of the invention uses a matching transconductor and transimpedence circuit to provide voltage gain. An embodiment of this aspect uses a transconductor in the form of a cross-coupled differential pair of field effect transistors to provide an output current from a voltage input, and a transimpedence in the form of a cross-coupled differential pair of field effect transistors, with negative feedback from output to input, to provide a voltage output. The whole arrangement thereby provides gain, of course, gain can be negative (attenuation).
The use of cross-coupled differential pairs provides a wide linear response. The use of matching transconductance and transimpedence arrangements ensures the gain is independent of process parameters, in the sense that the physical characteristics of production do not affect the performance because the active components are of the same type. Production variations are thus minimised.
The embodying arrangement also includes control of the voltage gain and/or attenuation by varying the ratio current between the transconductance and transimpedence. The control current is programmed using current digital to analog converters (DACs). The ratio of the DAC current, and hence the programming of the gain and/or attenuation, can also be made independent of process parameters.
A second aspect of the invention is a novel transimpedence arrangement comprising a transconductor with input connected to output with negative feedback. The embodiment is a cross-coupled differential pair with input connected to output, as used in the amplifier arrangement described above. The input and load linearisation leads to a small number of components in the signal path. The result is a wide bandwidth variable gain amplifier with a small group delay, which is both power and area efficient.
A third aspect of the invention resides in an electronics device comprising the semiconductor integrated circuit discussed. Such device may be any consumer electronics device, for example, DVD players, set-top boxes, amplifiers, or any device in which voltage amplification is required. Particular embodiments are a DVD player (which includes a player capable of recording), and hard disk drives.

BRIEF DESCRIPTION OF THE FIGURES

An embodiment of the invention will now be described by way of example only and with reference to the figures in which:

Figure 1:     shows a known transconductor comprising a source coupled differential pair;
Figure 2:     shows a known transconductor comprising a cross-coupled differential pair;
Figure 3:     shows a transimpedence arrangement according to one aspect of the invention;
Figure 4:     shows an amplifier arrangement according to another aspect of the invention;
Figure 4B:     shows a functional view of an alternative arrangement to that of Figure 4; and
Figure 5:     shows an optical media device incorporating the invention.

DESCRIPTION OF A PREFERRED EMBODIMENT

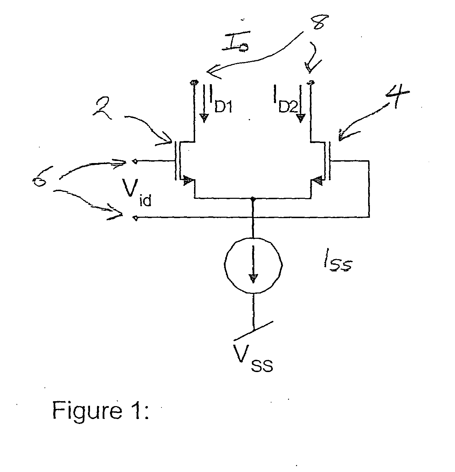

A known transconductor is shown in Figure 1. Briefly, the purpose of a transconductor is to convert a differential voltage input to a differential current output. Such devices are used in semiconductor circuits in which current mode signal processing is provided. The counterpart is a transimpedence which converts differential current to differential voltage. The transconductor shown comprises a FET pair 2, 4 connected so that a differential voltage input Vid across input terminals to control a differential output current to across output terminals 8. The output Io = ID1-ID2. The current source is Iss.

The output current Io can be derived (as is known to the skilled person) to be:

$$Io=ID1-ID2= \sqrt{2IssK}\ Vid\ \sqrt{1-\frac{K}{2Iss}}\ V2id$$

$$where\ \left| Vid \right| \leq \sqrt{\frac{Iss}{K}}\ or$$

$$Io=ID1-ID2=Iss\ sgn\ (Vid)$$

$$where\ \left| Vid \right| \geq \sqrt{\frac{Iss}{K}}$$

[Equation 1]

K is a constant related to the physical nature of the devices by K = Kn (W/L) where W = Width and L = Length of the active device (e.g. the FET channel).

The input stage is thus linear only over a limited range of differential input voltage. The non-linearity can be seen by expanding Equation 1 using a known McClaurin series to be:

$$Io= \sqrt{2IssK}\ Vid+0-\frac{K3/2}{2\sqrt{2IssK}}\ V3id\quad .........$$

[Equation 2]

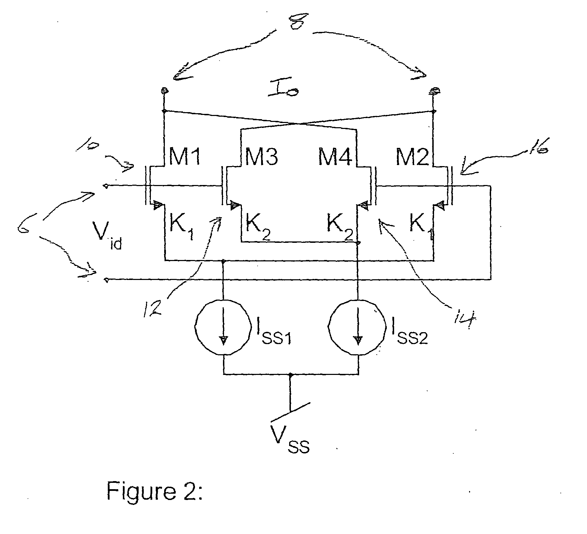

As can be seen, there is a linear gain term with Vid proportional to Io with the constant square root (2 IssK) and a non-linear term. To improve performance and reduce non-linearity a second known transconductor uses a cross-coupled differential pair, as shown in Figure 2. By selecting appropriate ratios of W/L for the devices (and hence the constant K=W/L), the non-linear term can be substantially cancelled. As shown in Equation 2, the non-linear term is proportional to K.

And so choosing W/L to cancel these terms gives:

$$3/2 \qquad 1/2$$

$$\left[\frac{(W/L)_1}{(W/L)_2}\right] = \left[\frac{I_{ss1}}{I_{ss2}}\right]$$

[Equation 3]

The resulting linear transconductance of the circuit in Figure 2 is given by:

$$gm=gm1=gm2=\sqrt{2I_{ss1}K_1}-\sqrt{2I_{ss2}K_2}$$

[Equation 4]

and therefore

$$gm=\sqrt{2I_{ss1}K_n}\sqrt{\frac{W/L1^4-W/L2^4}{W/L1^3}}$$

[Equation 5]

The width W and length L of devices are design choices and so selection of appropriate ratios allows the designer to cancel the third order (non-linear) term. The transconductance gm is the ratio of the applied voltage differential to the output differential current.

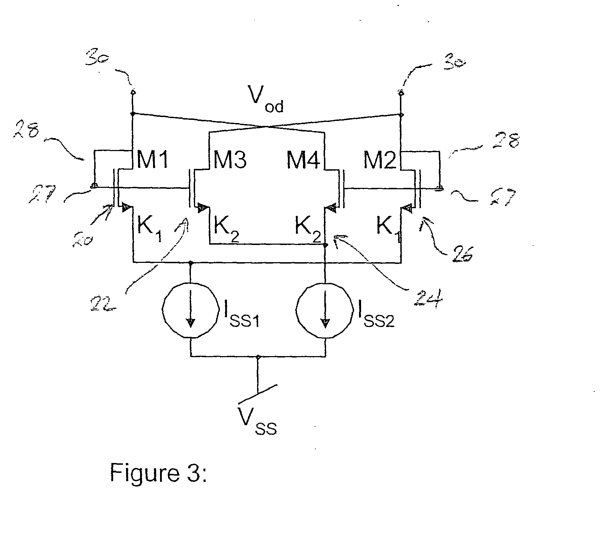

We have appreciated that a linear transimpedence can be created from a transconductance by connecting the input of the transconductor to its output with negative feedback. An embodiment of this aspect of the invention is shown in Figure 3 applying the technique to the transconductance of Figure 2. The benefits of linearity of the transconductance are gained. Also, such a transimpedence has improved performance in comparison to resistive loads (which have tolerance issues) and op-amps (which have more components).

The embodiment shown in Figure 3 is a transimpedence created from a cross-coupled pair transconductor. The input terminals 27 of the transconductor are connected by lines 28 to the output terminals 30. When functioning as a transconductor, the cross coupled arrangements of FETS 20, 22, 24, 26 would take a differential voltage at input terminals 27 and provide a differential output current at terminals 30. However, with the input and output terminals connected, a current received at terminals 30 causes a differential voltage between those terminals. The circuit has thus become a transimpedence with the input and output terminals being the same.

The circuit functions as follows. Current injected into the drain of each FET 20, 22, 24, 26 transfers to the source with any excess current going to the gate. The excess current at the gate causes a rising voltage (in similar manner to the charging of a capacitor) until the voltage level at the gate is such that the drain current and source current are equal, at which point there is no further current to the gate. This can be seen from the basic current summing law that the sum of currents in a circuit must be equal. Thus, the gate/source voltage is parasitic to the injected current in the sense that the voltage will vary to match the current injected. There is negative feedback because there is inversion in MOS devices i.e. a negative input gives a positive output.

The transimpedence circuit described is better than, say, a resistor which performs a similar current to voltage conversion, because resistors have poor tolerances, whereas the transimpedence described would depend on the ratios of W/L chosen to give a desired gm (transconductance) = IDIFF/VDIFF.

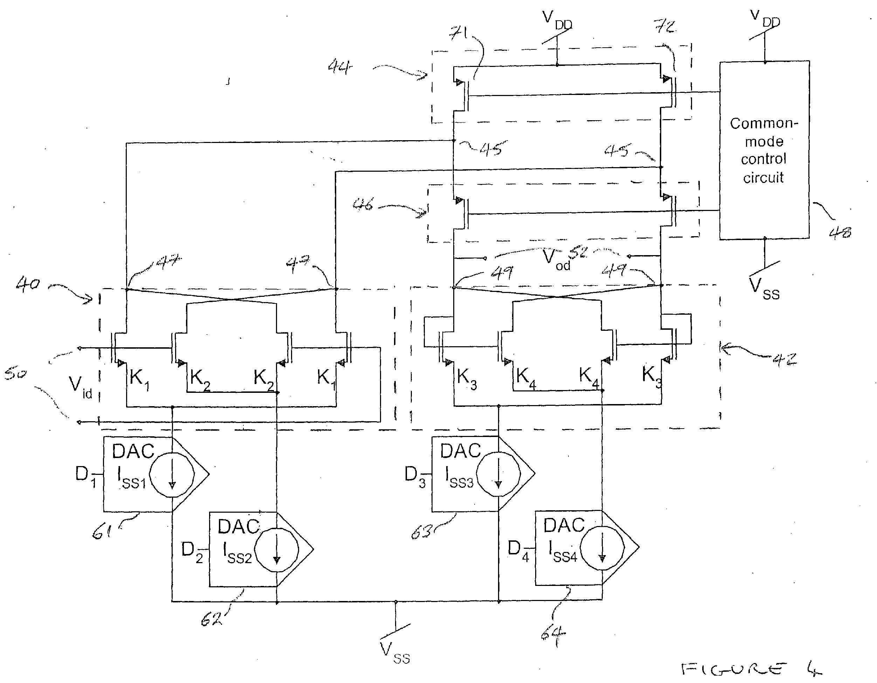

Another aspect of the invention is an amplifier comprising a matching transconductor and transimpedence an embodiment of which is shown in Figure 4. In particular, the transimpedence is arranged as the one shown and described in relation to Figure 3. The variable gain amplifier comprises a transconductor 40 (as shown in Figure 2) having input terminals 50 and a transimpedence 42 (as shown in Figure 3) having output terminals 52. A voltage Vid at input terminals 50 is given variable gain and presented as output voltage Vod at output terminals 52 via an intermediate current at junctions 45. The amplifier thus converts voltage to current and then current to voltage and provides gain by adjusting the operation of the transconductance and transimpedence.

The circuit of Figure 4 also includes a current source 44 and a cascode 46. The current source 44 allows the absolute current level at Junctions 45 to be adjusted as required. The cascode 46, decouples the voltage output at terminals 52 from the output of the current source.

A common mode central circuit 48 provides voltage control to the current source and cascode to control their operation. The gain of the amplifier is varied using digital to analogue current sources/drains, shown as current DACs 61, 62, 63, 64, which control the current through the transconductor and transimpedence. By controlling the current through the transconductor 40, the differential current at intermediate Junction 45 is varied so that the voltage to current conversion has a variable transconductance. Similarly, the variable current through the transimpedence 42 allows the transimpedence to be varied.

The overall gain of the amplifier is thus given by:

$$\text{Gain} = \frac{gm12}{gm34}$$

[Equation 6]

The gain can be rewritten using equation 5 as:

$$\text{Gain} = \sqrt{\frac{Iss1}{Iss3}\frac{\left[W/L1^4 - W/L2^4\right]}{\left[W/L3^4 - W/L4^4\right]}\frac{.W/L3^3}{.W/L3^3}}$$

[Equation 7]

As explained above, the current produced by current DACs, D1, D2, D3, D4, shown as Iss1, Iss2, Iss3 and Iss4 are variable and are digitally programmable. Thus the gain of the whole circuit is programmable by the current DACs.

As can be seen from Equation 7, the physical dimensions of the active devices (the FET channel) defined as width W and Length L govern the gain of the device. Choosing W/L1 = W/L3 and W/L2 = W/L4 optimises the variable gain amplifier operation around OdB. Choice of different W/L ratios, Iss1/Iss2 and Iss3/Iss4 ratios allows linearity to be optimised for different input and output voltage levels as well as for gain and/or attenuation.

The operation of the circuit in Figure 4 will be explained now in terms of the current flowing. There are two different controls of the current flow:

(i) The common mode control circuit 48 governs the current source by applying a controllable voltage to the gate of FETS 71 and 72. This sets the absolute current level at Junctions 45 and hence the current through transimpedence 42;

(ii) The DACs 61, 62, 63, 64 control the current flow into and out of the transconductor and transimpedence. This sets the variable gain level of the whole assembly.

The common mode control circuit controls the absolute current level and hence absolute voltage levels at Vod output 52. This could operate, for example, by using a pair of resistors across terminals 52 (not shown) to sense the voltage level and provide feedback to the common mode control circuit. The voltage applied to the gates of FETS 71, 72 sets the current from the source 44.

The DACs are digitally controlled current sources and so monotonic variations in current and hence gain of the amplifier is possible. The DACs themselves are known devices and need not be described further. Consider, though, the currents at Junctions 45. The sum at this point must be such that the current from the transconductor equals the current to the transimpedence plus/minus the current from the current source.

The cascode 46 comprises a FET pair arranged in known manner so that Vds (drain/source) can change significantly for Vgs (gate/source) to change only slightly. The output impedance is the output impedance of the current source and the gain of the cascode. Varying the output voltage has little effect on the input and so the output and input are effectively decoupled.

The circuit described has a number of advantages over known amplifiers. First, a wide bandwidth is provided because bandwidth is a function of transductance and capacitance, and these are kept to a minimum because there are few components. The fewer RC paths in the circuit have better exponential settling. A wide voltage suitability is provided because of the variable absolute voltage settling.

An alternative circuit is shown schematically in Figure 4B and comprises a transconductor 80 with input terminals 85 connected direct to a transimpedence 82 with output terminals 83. Such an arrangement could use the transimpedence as described in Figure 3 or other circuit and transconductance as in Figure 1 or 2, or other transconductance. Whilst such an arrangement would not have all the benefits of the circuit described, but it would function within the scope of an aspect of the invention.

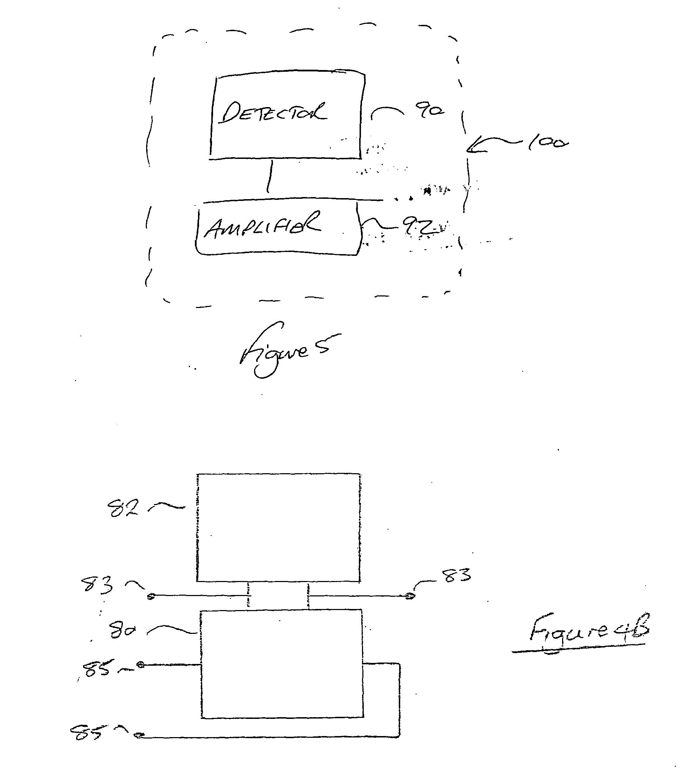

The amplifier circuit may be embodied in a variety of electronics devices, particularly optical media devices such as DVD or other disc players/ recorders. The amplifier is particularly suited to amplification of low level signals received from light detectors in such devices. A basic arrangement of an optical detector/ sensor 90 and an amplifier 92 embodying the invention in a media player 100 is shown in Figure 5.

**Claims**

1. An integrated circuit arranged to provide voltage gain, comprising:

   - a transconductor circuit (40) comprising a first cross-coupled differential pair having input terminals (50) arranged to receive a differential voltage and intermediate output terminals (45) arranged to produce a differential current; and
   - a transimpedence circuit (42) comprising a second cross-coupled differential pair with input and output connected with negative feedback and having input terminals (45) connected to the intermediate output terminals (45) and output terminals (52) arranged to produce a differential voltage output.

2. An integrated circuit according to claim 1, wherein the transimpedence circuit comprises substantially the same circuit elements as the transconductor circuit.

3. An integrated circuit according to claim 1 or 2, further comprising one or more variable current sources (61, 62, 63, 64) connected to the transconductor and/or the transimpedence arranged to vary the gain of the amplifier.

4. An integrated circuit according to claim 3, wherein the one or more variable current sources are arranged so that the differential current at the intermediate output terminals is variable according to the variable current sources.

5. An integrated circuit according to claim 3 or 4, wherein variable current sources comprise current DACs.

6. An integrated circuit arranged as a transimpedence for converting a current to a voltage comprising a transconductor semiconductor circuit comprising a cross-coupled differential pair having an input and an output, wherein the transconductor input and output are connected so as to provide negative feedback.

7. An electronics device comprising an integrated circuit according to any preceding claim.

8. An optical media reader or writer comprising an integrated circuit according to any of claims 1 to 6.

9. An optical disc player or recorder comprising a detector arranged to generate an output voltage from information on a disk and an integrated circuit according to any of claims 1 to 6 arranged to provide voltage gain of the output voltage.

10. An electronics device comprising a detector for converting received light from an optical storage medium into electrical signals, and an amplifier arranged to amplify the electrical signals, comprising:

- a transconductor circuit (40) comprising a first cross-coupled differential pair having input terminals (50) arranged to receive a differential voltage and intermediate output terminals (45) arranged to produce a differential current; and
- a transimpedence circuit (42) comprising a second cross-coupled differential pair with input and output connected with negative feedback and having input terminals (45) connected to the intermediate output terminals (45) and output terminals (52) arranged to produce a differential voltage output.

Figure 1:

Figure 2:

Figure 3:

FIGURE 4

11

DETECTOR ~ 90

~ 100

AMPLIFIER ~ 92

Figure 5

82 ~

83 ~

~ 83

80 ~

Figure 4B

85 ~

85 ~

**European Patent Office**

**EUROPEAN SEARCH REPORT**

Application Number

EP 06 25 2549

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | STANISLAW SZCZEPANSKI ET AL: "A Linear Fully Balanced CMOS OTA for VHF Filtering Applications" IEEE TRANSACTIONS ON CIRCUITS AND SYSTEMS II: ANALOG AND DIGITAL SIGNAL PROCESSING, IEEE INC. NEW YORK, US, vol. 44, no. 3, March 1997 (1997-03), XP011012632 ISSN: 1057-7130 *Section: III. High-Gain CMOS OTA with Negative Resistance Load* ----- | 1-10 | INV. H03F3/45 |
| X | SCHAUMANN R ET AL: "Mixed-mode automatic tuning scheme for high-Q continuous-time filters" IEE PROCEEDINGS: CIRCUITS DEVICES AND SYSTEMS, INSTITUTION OF ELECTRICAL ENGINEERS, STENVENAGE, GB, vol. 147, no. 1, 4 February 2000 (2000-02-04), pages 57-64, XP006013833 ISSN: 1350-2409 *Section: 4. Filter Topology* ----- | 1-10 | |
| A | WYSZYNSKI A ET AL: "VHF highly linear fully-balanced CMOS OTA" PROCEEDINGS OF THE INTERNATIONAL SYMPOSIUM ON CIRCUITS AND SYSTEMS. (ISCS). CHICAGO, MAY 3 - 6, 1993, NEW YORK, IEEE, US, vol. VOL. 2, 3 May 1993 (1993-05-03), pages 1156-1159, XP010115309 ISBN: 0-7803-1281-3 * the whole document * ----- | 1-10 | TECHNICAL FIELDS SEARCHED (IPC)  H03F |

-/--

The present search report has been drawn up for all claims

| Place of search | Date of completion of the search | Examiner |
|---|---|---|
| The Hague | 19 October 2006 | Aouichi, Mohamed |

**European Patent Office**

**EUROPEAN SEARCH REPORT**

Application Number

EP 06 25 2549

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BEHZAD RAZAVI: "Prospects of CMOS Technology for High-Speed Optical Communication Circuits" IEEE JOURNAL OF SOLID-STATE CIRCUITS, IEEE SERVICE CENTER, PISCATAWAY, NJ, US, vol. 37, no. 9, September 2002 (2002-09), XP011065838 ISSN: 0018-9200 *Section: VI.A. Broadband Amplification* ----- | 1-10 | |

TECHNICAL FIELDS SEARCHED (IPC)

The present search report has been drawn up for all claims

| Place of search | Date of completion of the search | Examiner |
|---|---|---|
| The Hague | 19 October 2006 | Aouichi, Mohamed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)